# EUROPEAN PATENT APPLICATION

(11) **EP 2 615 891 A1**
(43) Date of publication of application: **17.07.2013**
(21) Application number: 11823319.6
(22) Date of filing: 06.07.2011
(51) Int. Cl.: H05K 3/32, H01L 21/60, H01L 21/607

(54) **METHOD FOR SURFACE MOUNTING ELECTRONIC COMPONENT, AND SUBSTRATE HAVING ELECTRONIC COMPONENT MOUNTED THEREON**

(30) Priority: 07.09.2010 JP 2010199832
(71) Applicant: Omron Corporation, Kyoto-shi, Kyoto 600-8530 (JP)
(72) Inventor: KAWAI, Wakahiro, KYOTO-SHI KYOTO 600-8530 (JP)
(74) Representative: Kilian Kilian & Partner
(86) International application number: PCT/JP2011/065485
(87) International publication number: WO 2012/032840

(57) **Abstract**

Provided are a method for surface mounting an electronic component, in which a solder material is not used, and generation of cracks in a joint interface can be suppressed, and a substrate having the electronic component mounted thereon. The method for surface mounting an electronic component 40 includes the steps of: providing, on an insulating base material 10, a conductive circuit 21, and a resist 30, which is formed on a front surface of the conductive circuit 21, and which is made of a thermoplastic resin; providing a surface of the electrode 41 of an electronic component 40 with a metal layer 50; and bonding the metal layer 50 of the electronic component 40 and the conductive circuit 21 to each other by melting and partially removing the resist 30 by applying a load generated by ultrasonic vibration that vibrates in a direction substantially parallel to a surface of the metal layer 50, while pressing the metal layer 50 to the resist 30, and then stopping the application of the load generated by the ultrasonic vibration, and hardening a thermoplastic resin by cooling. The metal layer 50 is configured by a thin layer made of a material having a shear strength lower than that of a material constituting the conductive circuit 21.

## Description

### TECHNICAL FIELD

The present invention relates to a method for surface mounting an electronic component for surface mounting various types of electronic components such as a resistor or a capacitor on a printed wiring board on which a conductive circuit is formed, and a substrate having an electronic component mounted thereon.

### BACKGROUND ART

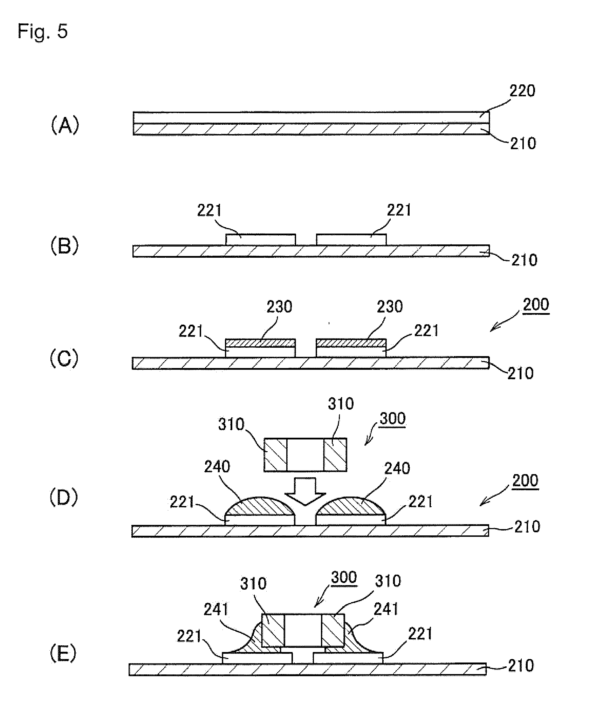

In general, a method using a solder material is used when various types of electronic components such as a resistor or a capacitor are surface mounted on a substrate. Such a conventional technique will be described with reference to Fig. 5. Fig. 5 is a process diagram illustrating surface mounting procedures according to Conventional Example 1.

In this conventional example, a copper foil 220 having a thickness of about 12 µm to 35 µm is laminated on a surface of a base material 210 made of a heat-resistant glass epoxy resin or polyimide resin, and this is used as a substrate (see Fig. 5(A)). A conductive circuit 221 is formed on the substrate using a conventionally known photolithography method and etching method (see Fig. 5(B)). In addition, a printed wiring board 200 is produced by applying plating 230 of Sn or the like to a position where an electronic component 300 is connected to impart wettability with a solder material (see Fig. 5(C)).

Next, a solder paste 240 is applied onto the plating 230 of the conductive circuit 221 by screen printing or the like. Then, an electrode 310 of the electronic component 300 is placed on the solder 240 (see Fig. 5(D)). The solder 240 is heated and melted at a temperature of 260 to 270°C for several seconds while the electronic component 300 is placed, and is hardened by cooling after a fillet 241 is formed. Subsequently, a flux material in the solder 240 is removed by cleaning, so that mounting of the electronic component 300 onto the conductive circuit 221 is completed.

Incidentally, further miniaturization of a printed wiring board and further high-density packaging of electronic components on a substrate have been demanded in recent years along with miniaturization of an electronic device. As a result, an area of a conductive circuit is reduced, which increases a risk of troubles such as a bonding failure due to insufficient supply of a solder material, or a short circuit between adjacent circuits due to protrusion of the solder material. It is necessary to provide an area of a conductive circuit to a certain degree to form a fillet that secures a bonding reliability of the solder. However, the above-mentioned packaging method has a limitation in miniaturization.

To resolve such problems, there are proposed a method for using a connection sheet formed of a sheet-like solder material with a flux film laminated thereon, a method for using an anisotropically conductive sheet or an anisotropically conductive paste, or the like (see Patent Document 1). However, such a method increases a material cost incurred by forming the solder material or the like into a film shape or by using anisotropically conductive material, and a heating process cannot be eliminated. As a result, such a method cannot cope with a demand for decreasing cost.

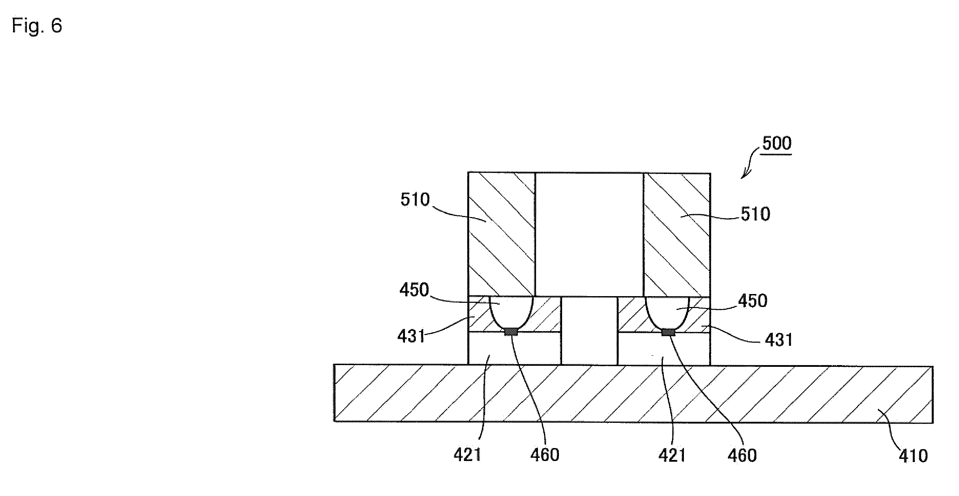

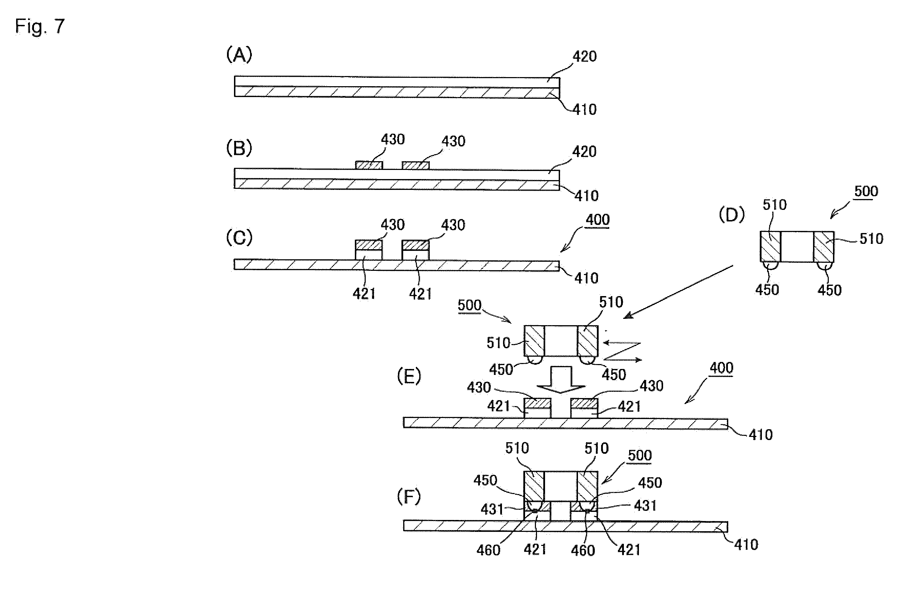

In addition, the applicant of the present application has already proposed a method for surface mounting without using a solder material, as a method to cope with the demand for miniaturization and decreasing cost simultaneously (see Patent Document 2). Such a method will be described with reference to Figs. 6 and 7. Fig. 6 is a schematic cross sectional view of a substrate on which an electronic component is mounted, which is produced by a method for surface mounting according to Conventional Example 2. Fig. 7 is a process diagram illustrating surface mounting procedures according to Conventional Example 2.

In this conventional example, a metal foil 420 is laminated on a surface of an insulating base material 410 made of a glass epoxy resin or the like, and this is used as a substrate (see Fig. 7(A)). A thermoplastic resin material (hereinafter, referred to as "resist") formed as an ink material is coated on a surface of the substrate so as to form a predetermined pattern (see Fig. 7(B)). Then, a conductive circuit 421 is formed by etching and removing the metal of an exposed portion that is not covered with a resist 430. In this way, a printed wiring board 400 on which the conductive circuit 421 is formed can be provided (see Fig. 7(C)).

In addition, in a separate process, a protruding electrode 450 is formed by plating, a stud bump method which is conventionally known, or the like on a surface of an electrode 510 of an electronic component 500 (see Fig. 7(D)).

Then, the electronic component 500 is pressed onto the resist 430, which is heated at a temperature of about 60°C, on a surface of the printed wiring board 400 so that the protruding electrode 450 makes contact therewith while ultrasonic vibration is applied (see Fig. 7(E)). With this arrangement, a portion of the resist 430 to which a tip end of the protruding electrode 450 is pressed melts and is removed by friction caused between the protruding electrode 450 and the resist 430. Then, a metal fused portion 460 is formed by friction caused by the ultrasonic vibration between the tip end of the protruding electrode 450 and the conductive circuit 421. Thereafter, the resist 430 made of a thermoplastic resin is cooled and hardened again by stopping the ultrasonic vibration, and the electrode 510 of the electronic component 500 and the conductive circuit 421 are electrically connected to each other through the protruding electrode 450 and the metal fused portion 460 (see Fig. 7(F) and Fig. 6).

By using the method for surface mounting as described above, it is not necessary to use the solder, and it is possible to respond to both the demand for miniaturization and the demand for decreasing cost.

However, according to the foregoing method for surface mounting, there is a problem in which there is a high risk for causing cracks in the interfaces between the electrode 510 of the electronic component 500 and the protruding electrode 450, and between the protruding electrode 450 and the metal fused portion 460, during the process of applying the ultrasonic vibration.

To state it differently, the mechanism of bonding utilizing the ultrasonic vibration involves occurrences of relative sliding friction of a joint interface, destruction of a surface oxide film, metallic diffusion, and completion of bonding, in this order. However, the flow of these sequences does not take place in an entire joint interface simultaneously, but there is a case where even a portion in which bonding is completed is continuously subjected to a load generated by the ultrasonic vibration. In this case, the stress caused by the ultrasonic vibration cannot be fled through interface slip, and a shear stress is exerted on the bonded portion. Accordingly, cracks tend to be caused near the bonded portion, because, generally, the welded portion has a large deformation strength.

Further, according to the foregoing method for mounting, there is also a problem in which the cost for forming the protruding electrode 450 having a protruding shape is high.

Patent Document 1: Japanese Unexamined Patent Publication No. 2005-203693
Patent Document 2: Japanese Patent No. 3584404

### SUMMARY OF THE INVENTION

### PROBLEMS TO BE SOLVED BY THE INVENTION

It is an object of the present invention to provide a method for surface mounting an electronic component, and a substrate having an electronic component mounted thereon, which do not use a solder material and can suppress generation of cracks in a joint interface.

### MEANS FOR SOLVING THE PROBLEM

According to the present invention, the following methods are used to solve the foregoing problem.

Specifically, a first method for surface mounting an electronic component includes the steps of: providing, on a substrate member, a conductive circuit, and a thermoplastic resin layer which is formed on a front surface of the conductive circuit; providing a surface of an electrode of an electronic component with a metal layer; and bonding the metal layer of the electronic component and the conductive circuit to each other by melting and then partially removing a thermoplastic resin by applying a load generated by ultrasonic vibration that vibrates in a direction substantially parallel to a surface of the metal layer, while pressing the metal layer to the thermoplastic resin layer, and then stopping applying the load generated by the ultrasonic vibration, and hardening the thermoplastic resin thus melted by cooling. Here, the metal layer is configured by a thin layer made of a material having a shear strength lower than that of a material constituting the conductive circuit.

According to the present invention, it is possible to perform surface mounting an electronic component without using a solder material.

Further, the metal layer is configured by a thin layer made of a material having a shear strength lower than that of a material constituting the conductive circuit. Accordingly, it is possible to suppress breakage of the conductive circuit even in the case where a load generated by the ultrasonic vibration is applied.

In addition, as a result of employing the foregoing structure for the metal layer, a load caused by the shear stress can be suppressed in the bonded portion (referred to as "first bonded portion" for convenient sake) between the electrode of the electronic component and the metal layer and in the bonded portion (referred to as "second bonded portion" for convenient sake) between the metal layer and the conductive circuit. The reasons are described below.

First, as compared with a case where the thermoplastic resin layer is partially removed from a tip end of the protruding electrode utilizing the ultrasonic vibration, and the protruding electrode and the conductive circuit are joined together, an area of the second bonded portion is wider, and therefore the shear stress can be reduced. Second, as compared with a case of the protruding electrode, the thickness (this corresponds to the thickness of the layer of the metal layer in the case of this embodiment, or a protruding amount in the case of the protruding electrode) can be reduced, the stress moment caused between the first bonded portion and the second bonded portion can be reduced, and therefore the shear stress in each of the bonded portions can be reduced. Third, as compared with a case of the protrusion electrode, a larger elastic deformation area is provided, the ductility is increased, and therefore it is easy to absorb the shear stress.

As described above, according to the present invention, breakage of the conductive circuit is deterred, the load caused by the shear stress exerted on each bonded portion can be suppressed, and therefore it is possible to suppress the occurrence of cracks in the joint interface.

It is preferable to disperse particles made of a material having a Mohs hardness larger than that of the material constituting the conductive circuit in the thermoplastic resin layer.

With this arrangement, a "filing effect" of scratching the metal surface by the particles dispersed in the thermoplastic resin layer caused by vibration when the load generated by the ultrasonic vibration is applied is exerted. With this arrangement, an inert layer (oxide film) on the metal surface is removed, and bonding of metal starts. Accordingly, even in the case where the Mohs hardness of the metal layer is smaller than that of the conductive circuit, bonding through destruction of the oxide film on the surface of the conductive circuit can be appropriately performed.

In addition, the second invention is directed to a method for surface mounting an electronic component, including the steps of: providing, on a substrate member, a conductive circuit, and a metal layer which is formed on a front surface of the conductive circuit; providing a front surface of the metal layer with a thermoplastic resin layer; and bonding an electrode of an electronic component and the metal layer to each other by melting and partially removing a thermoplastic resin by applying a load generated by ultrasonic vibration that vibrates in a direction substantially parallel to a surface of the electrode, while pressing the surface of the electrode to the thermoplastic resin layer, and then stopping applying the load generated by the ultrasonic vibration, and hardening the thermoplastic resin thus melted by cooling. Here, the metal layer is configured by a thin layer made of a material having a shear strength lower than that of a material constituting the conductive circuit.

In this second invention, for the same reason as in the case of the first invention, it is possible to deter the breakage of the conductive circuit, and suppress a load caused by the shear stress exerted to each bonded portion, and therefore occurrence of cracks in the joint interface can be suppressed.

Further, according to the substrate having an electronic component mounted thereon of the present invention, the electronic component is mounted on a substrate member by any one of the methods for surface mounting an electronic component described above.

### EFFECT OF THE INVENTION

As described above, according to the present invention, it is possible to suppress occurrence of cracks in the joint interface without using the solder material.

### BRIEF DESCRIPTION OF THE DRAWINGS

Fig. 1 is a schematic cross sectional view of a substrate on which an electronic component is mounted, according to Embodiment 1 of the present invention.
Fig. 2 is a process diagram illustrating surface mounting procedures in a method for surface mounting the electronic component, according to Embodiment 1 of the present invention.
Fig. 3 is a descriptive diagram of a method for surface mounting an electronic component, according to Embodiment 2 of the present invention.
Fig. 4 is a process diagram illustrating surface mounting procedures in a method for surface mounting the electronic component, according to Embodiment 3 of the present invention.
Fig. 5 is a process diagram illustrating surface mounting procedures according to Conventional Example 1.
Fig. 6 is a schematic sectional view of a substrate with an electronic component mounted thereon, which is obtained by a method for surface mounting according to Conventional Example 2.
Fig. 7 is a process diagram illustrating surface mounting procedures according to Conventional Example 2.

### MODE FOR CARRYING OUT THE INVENTION

Hereinafter, embodiments for carrying out this invention will be exemplified and described in detail based on embodiments with reference to the drawings. However, dimensions, materials, shapes, relative positions, and the like described in the embodiments are not purposed for limiting the scope of this invention thereto unless otherwise specifically described so.

### (Embodiment 1)

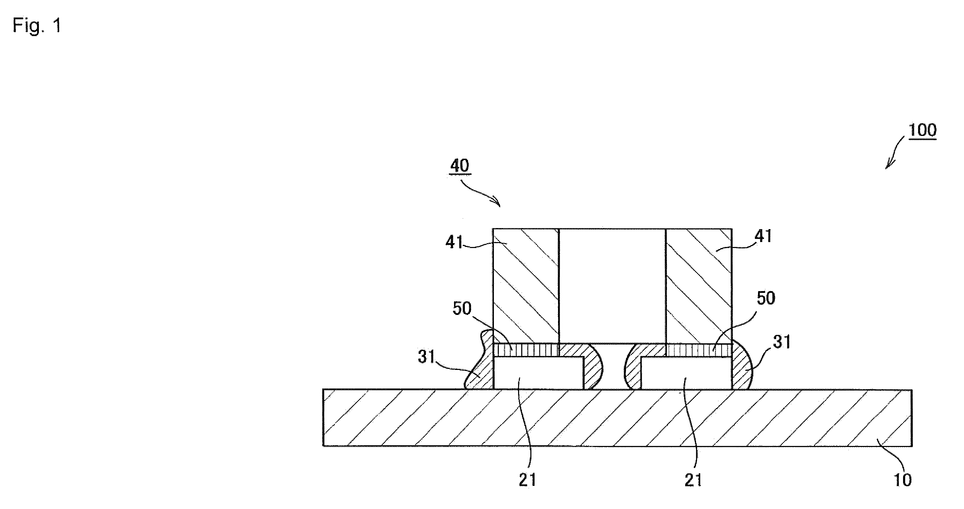

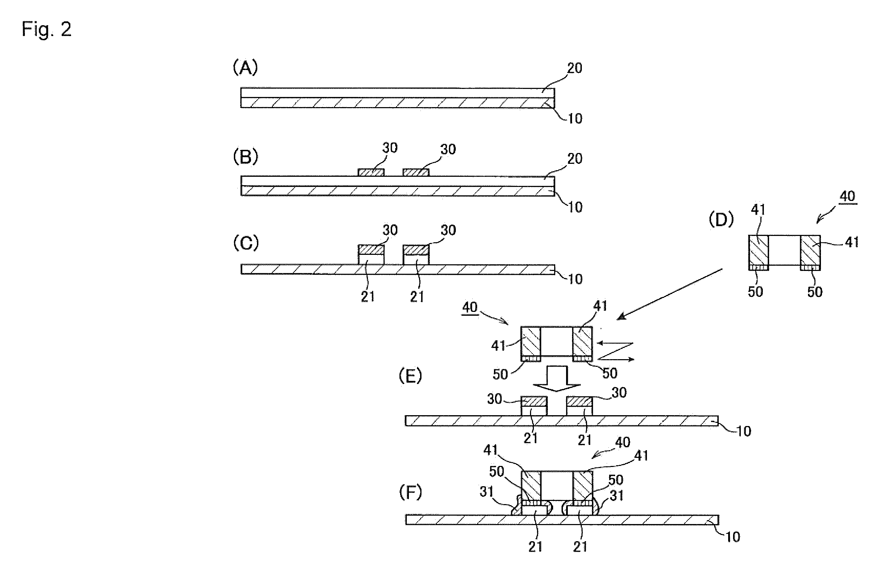

A description will be given of a method for surface mounting an electronic component, and a substrate having an electronic component mounted thereon according to Embodiment 1 of the present invention, with reference to Figs. 1 and 2.

### <Substrate having an electronic component mounted thereon>

Referring, in particular, to Fig. 1, a substrate having an electronic component produced by a method for surface mounting an electronic component according to Embodiment 1 of the present invention will be described.

A substrate 100 having an electronic component mounted thereon according to this embodiment includes an insulating base material 10 as a substrate member, a conductive circuit 21 formed on a surface of the insulating base material 10, and metal layers 50 provided on a pair of electrodes 41 of an electronic component 40 and fixed while being electrically connected to the conductive circuit 21. Further, the substrate 100 is also provided with a resin fixing portion 31 that functions to further reinforce fixing between the insulating base material 10 and the electronic component 40.

Here, a glass epoxy resin is named as a preferred example as a material of the insulating base material 10. In addition, in this embodiment, various types of electronic components that can be mounted by surface mounting, such as a resistor and a capacitor, are applied as the electronic component 40.

### <Method for surface mounting an electronic component>

Referring, in particular, to Fig. 2, a method for surface mounting an electronic component according to this embodiment will be described.

### <<Process 1>>

A metal foil 20 is laminated on a surface of the insulating base material 10 (see Fig. 2(A)).

As a specific example, the metal foil 20 made of hard aluminum having a thickness of 35 µm is placed on one side of the insulating base material (Garaepoprepreg) 10 made of glass epoxy having a thickness of 50 µm, which are joined together by hot press. Since this bonding method is a publicly known technique, and the detailed description thereof will be omitted.

As a result of this, the insulating base material 10 including the metal foil 20 laminated on a surface thereof can be obtained. Here, a copper foil having a thickness of 18 µm is named as another specific example of the metal foil 20.

### «Process 2»

A desired pattern shape (shape of the conductive circuit) of a resist 30 is formed on a surface of the metal foil 20 by an ink material made of a thermoplastic resin (see Fig. 2(B)).

As a specific example, a desired pattern shape of the resist 30 (thermoplastic resin layer) is formed on the surface of the metal foil 20 by a polyolefin thermoplastic adhesive or the like which melts at a temperature of about 150°C. The resist 30 is formed by coating to a thickness of about 2 to 3 µm by a method such as gravure printing.

### <<Process 3>>

The metal foil 20 in an exposed position which is not covered with the resist 30 is removed by etching to thereby form the conductive circuit 21. A surface of this conductive circuit 21 is covered with the resist 30 serving as a thermoplastic resin layer (see Fig. 2(C)).

As a specific example, as an etching process, it is preferable to use NaOH (120 g/l) as an etchant at a temperature condition of 50°C. Here, it is also possible to use a polyester plastic resin instead of the polyolefin thermoplastic resin which is used for the resist 30. In this case, FeCl₂ of an acid system is used as the etchant during etching.

In this embodiment, an area of the bonded portion of the conductive circuit 21 can be made smaller than an area of the bonded portion of the electrode 41 of the electronic component 40. For this reason, the area of the bonded portion of the conductive circuit 21 can be made smaller as compared with the conventional method for mounting using a solder material (e.g., in the case of a chip capacitor having a size of 1.0 mm by 0.5 mm, an area about a twice an electrode area is necessary).

### «Separate process»

In the separate process, a metal layer 50 serving as a thin layer having a thickness of about 1 µm is formed, by plating or the like, on an entire surface on a side to be joined of the electrode 41 of the electronic component 40 (see Fig. 2(D)). Here, a material used to form the metal layer 50 is a material having a shear strength (shearing resistance) smaller than that of a material constituting the conductive circuit 21. In addition, both surfaces of the metal layer 50 are formed to have flat surfaces.

As a specific example, the metal layer 50 is formed to have a thickness of about 1 µm by a conventional gold plating method using gold having a shear strength of 1600 kg/cm² on an entire surface on a side to be joined to the conductive circuit 21, and this is applied to each of the pair of electrodes 41 of a chip capacitor (electronic component 40) having a size of 1.0 mm by 0.5 mm.

Here, when the conductive circuit 21 is formed of aluminum, the shear strength is about 2000 to 3000 kg/cm², and about 3000 kg/cm² or more when it is formed of copper. Accordingly, in any of the cases, the shear strength of the metal layer 50 is lower than the shear strength of the conductive circuit 21.

In this embodiment, the case where the metal layer 50 is provided only on a surface of the electrode 41 on a side to be joined to the conductive circuit 21. However, it is also possible to form the metal layer 50 on an entire exposed surface of the electrode 41. In this case, it is not necessary to make an arrangement so that plating is not applied to surfaces (upper surface and side surfaces) other than the surface of the electrode 41 on the side to be joined, so that a process of forming the metal layer 50 can be simplified.

### «Process 4»

A load generated by ultrasonic vibration vibrating in a direction substantially parallel to a surface of the metal layer 50 is applied while the metal layer 50 provided on the surface of the electrode 41 of the electronic component 40 is pressed against the resist 30 serving as the thermoplastic resin layer (see Fig. 2(E)). This process is performed while the insulating base material 10 having the conductive circuit 21 on which the resist 30 is formed is heated to a temperature of about 60°C.

By applying a load by ultrasonic vibration while a load by pressure is applied, a part of the resist 30 formed of the thermoplastic resin is removed from the surface of the conductive circuit 21 by mechanical friction caused by the ultrasonic vibration. To state it differently, a part of the resist 30 melts by frictional heat, and the resin that is melted by pressure is pushed away in a direction perpendicular to a direction in which the pressure is exerted and removed from a region between the surface of the metal layer 50 and the surface of the conductive circuit 21.

At the same time, an oxide layer on the surface of the conductive circuit 21 is also mechanically removed so that the surface of the metal layer 50 on the electrode 41 makes contact with the surface of the conductive circuit 21. Furthermore, a metal fused portion is formed between these surfaces by the friction caused by the ultrasonic vibration.

Subsequently, by stopping applying the load generated by the ultrasonic vibration, the thermoplastic resin that has been melted by heat is hardened again by cooling. With this arrangement, the resin fixing portion 31 exerting a function of reinforcing the fixing between the insulating base material 10 and the electronic component 40 is formed (see Fig. 2(F)).

As a specific example, the load generated by the ultrasonic vibration at a vibration frequency of 63 kHz is applied while the metal layer 50 provided on the electrode 41 of the chip capacitor (electronic component 40) is pressed against the resist 30 under the condition of a pressure of 0.2 kg/mm².

The process of applying the load is performed for about 0.3 seconds. With this arrangement, the chip capacitor is firmly fixed on the insulating base material 10, and the electrode 41 of the chip capacitor and the conductive circuit 21 on the insulating base material 10 can be electrically connected to each other through the metal layer 50. As described above, since the metal fused portion is formed between the metal layer 50 and the conductive circuit 21, they are firmly fixed together.

Although a case of using gold as one example of a material of the metal layer 50 is described, the material of the metal layer 50 is not limited to gold. A material having conductivity, and a shear strength (shearing resistance) smaller than that of a material constituting the conductive circuit 21 may serve as the material of the metal layer 50. Accordingly, other than gold, aluminum, zinc, nickel, copper, or an alloy made by arbitrarily combining these, or the like can be used according to the material that constitutes the conductive circuit 21.

Further, as one example of the insulating base material 10, the material made of glass epoxy having a thickness of 50 µm is described. However, the material and the thickness of the insulating base material 10 are not limited to this example.

In this embodiment, since a time required for applying the load generated by the ultrasonic vibration is very short. Therefore, heat caused by the friction is not conducted to the insulating base material 10. For this reason, it is possible to use a PET film (e.g., thickness of 25 µm) having low heat resistance with a melting point of about 120°C can be used as the insulating base material 10.

### <<Excellent points of the method for surface mounting an electronic component according to this embodiment»

### <<Effect produced by disuse of solder material>>

As described above, according to the method for surface mounting of this embodiment, it is possible to mount the electronic component 40 on the insulating base material 10 without using the solder material. Accordingly, the following effects can be provided.

The method does not provide a problem such as a disconnection of line or short-circuiting caused by insufficient supply or protrusion of the solder material, and therefore the area of the conductive circuit 21 can be made smaller. There is no need to form a fillet for securing a reliability in solder bonding, and therefore the area of the conductive circuit 21 can be made smaller. The method does not provide a problem of wettability of materials constituting the solder material and the conductive circuit 21, and therefore the cost for material can be reduced because plating on the surface of the conductive circuit 21 can be eliminated, inexpensive aluminum can be employed as a material of the conductive circuit 21, and the like. Heat treatment for melting the solder material is not necessary, and therefore an inexpensive low heat resistant material such as PET (polyethylene terephthalate) can be used as a material for the base material (insulating base material 10) of the printed wiring board. By reducing apparatuses required for heat treatment at a high temperature and energy used therefor, a further reduction in manufacturing cost is possible. Additionally, it is possible to save the impact on the environment by reducing the used energy, or the solder material and the flux material which are required in the conventional method.

Further, cracks, voids, and whiskers resulted from using the solder material are not caused, and a reduction in quality such as uplift of the electronic component is not caused. Moreover, works which are required in the conventional method such as removing of etching resist, coating of resist, plating, supplying solder material, heat treatment, and cleaning of flux material are not necessary, and therefore the processing steps can be drastically reduced. As a result of this, it is possible to reduce the manufacturing cost and improve the productivity.

### <<Effects provided by forming the metal layer using a thin layer made of a material having a smaller shear strength>>

As described above, in this embodiment, the metal layer 50 provided on the surface of the electronic component 40 is formed of a thin layer (a layer having a flat surface on a side of the conductive circuit 21) made of a material having a shear strength smaller than that of the material constituting the conductive circuit 21. Accordingly, the following effects can be provided.

Specifically, in this embodiment, as a result of employing the foregoing structure as the metal layer 50, it is possible to prevent the conductive circuit 21 from being broken even if a load is applied by the ultrasonic vibration. This is because the shear strength of the conductive circuit 21 is higher than that of the metal layer 50, and the surface of the metal layer 50 is a flat surface.

In addition, as a result of employing the foregoing structure for the metal layer 50, a load caused by the shear stress can be suppressed in the bonded portion (referred to as "first bonded portion" for convenient sake) between the electrode 41 of the electronic component 40 and the metal layer 50 and in the bonded portion (referred to as "second bonded portion" for convenient sake) between the metal layer 50 and the conductive circuit 21. The reasons are described below.

First, as compared with a case where the thermoplastic resin layer is partially removed from a tip end of the protruding electrode utilizing the ultrasonic vibration, and the protruding electrode and the conductive circuit are joined together, an area of the second bonded portion is wider, and therefore the shear stress can be reduced.

Second, as compared with a case of the protruding electrode, the thickness (this corresponds to the thickness of the layer of the metal layer 50 in the case of this embodiment, or a protruding amount in the case of the protruding electrode) can be reduced, and therefore the stress moment caused between the first bonded portion and the second bonded portion can be reduced, and therefore the shear stress in each of the bonded portions can be reduced.

Third, as compared with a case of the protrusion electrode, the metal layer 50 according to this embodiment has a larger elastic deformation area, the ductility is increased, and therefore it is easy to absorb the shear stress.

As described above, according to this embodiment, breakage of the conductive circuit 21 is deterred, the load caused by the shear stress exerted on each bonded portion can be suppressed, and therefore it is possible to suppress the occurrence of cracks in the joint interface.

In addition, in the conventional case where the protruding electrode is employed, it is necessary to provide a process of forming a plating mask or the like, whereas, in this embodiment, such a process is not necessary, and therefore it is possible to perform surface mounting the electronic component at a low cost corresponding to about 50% of the cost required in the conventional process.

### (Embodiment 2)

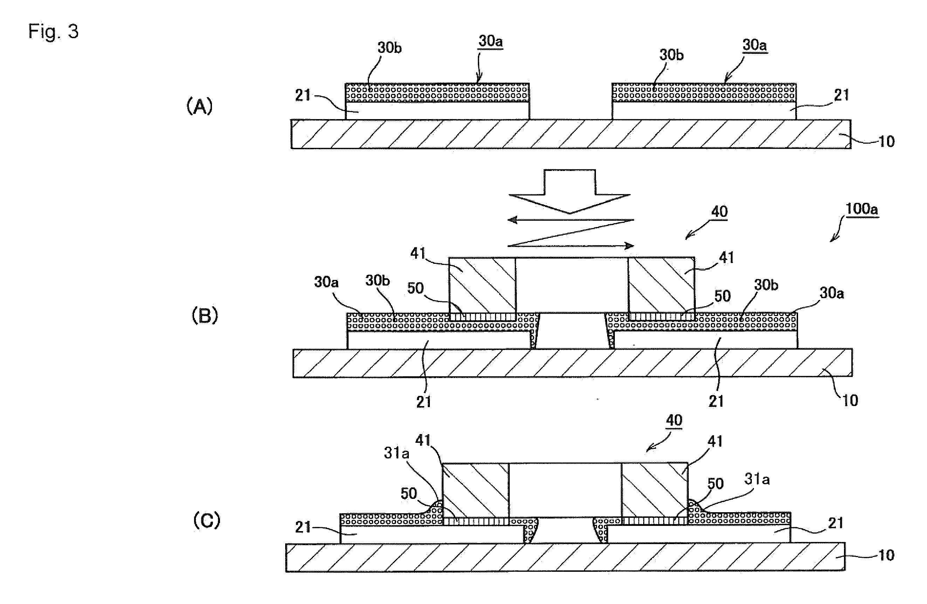

Fig. 3 illustrate Embodiment 2 of the present invention. In this embodiment, a case where particles made of a hard material are dispersed in a thermoplastic resin layer (resist) based on the structure indicated in Embodiment 1. Other structures and working are identical with those of Embodiment 1, and therefore identical constituent portions are identified with identical reference numerals, and the descriptions thereof will be omitted.

As described in Embodiment 1, a material having a shear strength smaller than that of a material constituting the conductive circuit 21 can be employed as a material of the metal layer 50. For example, it is possible to use tin (Sn) having a shear strength of about 200 kg/cm².

However, to electrically connect the metal layer 50 and the conductive circuit 21 together, it is necessary to fuse and remove a part of the thermoplastic resin (resist 30) by the metal layer 50 by applying a load generated by the ultrasonic vibration, and also remove a layer of an oxide on the surface of the conductive circuit 21.

Here, the Mohs hardness of tin is about 1.5 which is lower than the Mohs hardness of aluminum or copper. The Mohs hardness of aluminum is 2.75, and the Mohs harness of copper is 2.5 to 3.0.

Accordingly, when tin is employed as a material of the metal layer 50 in the case where copper or aluminum is used as a material of the conductive circuit 21, removing the layer of an oxide on the surface of the conductive circuit 21 by the ultrasonic friction is difficult to progress, and the formation of the metal fused portion between the metal layer 50 and the conductive circuit 21 s difficult to progress.

In this embodiment, a method for forming the metal fused portion in a preferable manner between the metal layer 50 and the conductive circuit 21 will be described even in the case where a material such as tin having a small Mohs hardness is employed as a material of the metal layer 50.

Specifically, this embodiment adopts, for a resist 30a, a structure in which particles 30b made of a material having a Mohs hardness that is larger than a Mohs hardness of a material constituting the metallic layer 50 and at the same time larger than a Mohs hardness of a material constituting the conductive circuit 21 are dispersed in a thermoplastic resin layer having a thickness of about 2 µm to 3 µm (see Fig. 3(A)).

A polyolefin resin is named as a preferred example of the thermoplastic resin. Further, named as a preferred example as the particles 30b are particles that are made of ceramic such as SiO₂, Al₂O₃, or SiC, and have a substantially spherical shape and a diameter of 0.3 µm or larger and 0.5 µm or smaller.

The method for surface mounting (process) is the same as that of Embodiment 1, and therefore the description thereof will be omitted.

As described above, in this embodiment, a resist 30a in which the particles 30b having a large Mohs hardness are dispersed in the thermoplastic resin layer is employed. As a result, in the process of applying the load generated by the ultrasonic vibration in Process 4 which is described in Embodiment 1, what is different from Embodiment 1 is that a frictional force by the particles 30b is applied to the metal layer 50 and the conductive circuit 21. Fig. 3(B) is a schematic cross sectional view illustrating a state, before the metal layer 50 and the conductive circuit 21 make contact with each other, in which a load generated by the ultrasonic vibration is applied, and a part of the thermoplastic resin melts and is removed. Further, Fig. 3(C) is a schematic cross sectional view of a substrate on which the electronic components is mounted (schematic cross sectional view illustrating a state after the process of applying the load generated by the ultrasonic vibration). As illustrated, and as in the case of Embodiment 1, the thermoplastic resin that has been melted by heat is hardened again by cooling, and a resin fixing portion 31a exerting a function of reinforcing the fixing between the insulating base material 10 and the electronic component 40 is formed.

In Process 4 described in Embodiment 1, when the metal layer 50 and the conductive circuit 21 make frictional contact with each other by the ultrasonic vibration, if there is a difference in the Mohs hardness between the two, destruction of the surface oxide film of the one having a higher Mohs hardness does not progress, which poses a problem of a difficulty in forming the metal fused portion. However, according to this embodiment, the particles 30b dispersed in the thermoplastic resin rub against the interface between the metal layer 50 and the conductive circuit 21, and therefore the surface oxides of the both are uniformly destroyed, so that the metal fused portion can be formed in a preferable manner.

As described above, according to this embodiment, even in the case where a material such as tin having a small Mohs hardness is used as the material of the metal layer 50, the metal fused portion can be formed between the metal layer 50 and the conductive circuit 21 in a preferable manner.

### (Embodiment 3)

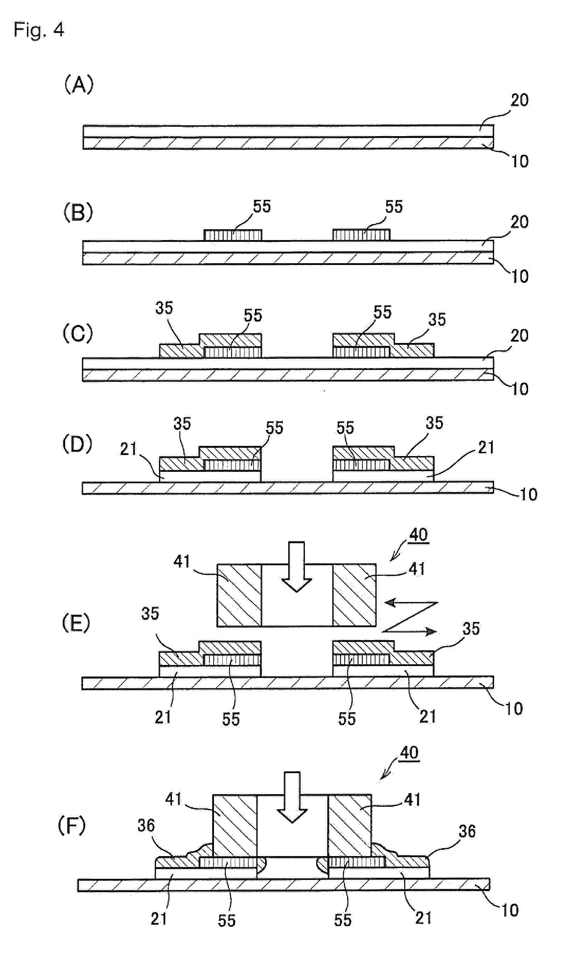

Fig. 4 illustrates Embodiment 3 of the present invention. In Embodiment 1, the case where the metal layer is provided on the side of the electrode of the electronic component is described, as a process before fixing the electronic component to the insulating base material. In this embodiment, a case where the metal layer is provided on the side of the insulating base material will be described. Other structures and working are identical with those of Embodiment 1, and therefore identical constituent portions are identified with identical reference numerals, and the descriptions thereof will be omitted.

In Embodiment 1, the case where the metal layer 50 is provided on the surface of the electrode 41 of the electronic component 40 is described, as a process before fixing the electronic component 40 to the insulating base material 10. However, a surface on a bonding side of the electrode 41 to be joined to the conductive circuit 21 has a sufficient area. Therefore, it is not necessary to position the electronic component 40 with respect to the conductive circuit 21 with a high degree of accuracy in Process 4 in Embodiment 1.

Accordingly, for the purpose of reducing the cost or the like, it is also possible to provide the metal layer on the side of the insulating base material 10 (to be more specific, on the surface of the conductive circuit 21) as a process before the electronic component 40 is fixed to the insulating base material 10.

### <Method for surface mounting an electronic component>

Referring, in particular, to Fig. 4, a method for surface mounting an electronic component according to this embodiment will be described.

### «Process 1>>

As in the case of Embodiment 1, a metal foil 20 is laminated on a surface of the insulating base material 10 (see Fig. 4(A)).

As a specific example, the metal foil (copper foil) 20 having a thickness of 18 µm is placed on one side of the insulating base material (Garaepoprepreg) 10 made of glass epoxy having a thickness of 50 µm, which are joined together by hot press. As a result of this, the insulating base material 10 including the metal foil 20 laminated on a surface thereof can be obtained.

### «Process 2>>

After a desired pattern shape of a resist for plating is formed on a surface of the metal foil 20, a metal layer 55 is formed through the conventional plating process (electroless plating or electrolytic plating process) on an exposed portion of the metal foil 20 which is not covered with the resist for plating. As in the case of Embodiment 1, a material used to form the metal layer 55 is a material having a shear strength (shearing resistance) smaller than that of a material constituting the conductive circuit 21. In addition, both surfaces of the metal layer 55 are formed to have flat surfaces. As in the case of Embodiment 1, this metal layer 55 is also formed of a thin layer having a thickness of about 1 µm. Further, as in the case of Example 1, gold, aluminum, zinc, nickel, copper, or an alloy made by arbitrarily combining these, or the like can be used according to the material that constitutes the conductive circuit 21, also as the material of this metal layer 55.

After the metal layer 55 is formed, the resist for plating is peeled off from the metal foil 20 (see Fig. 4(B)). Fig. 4 does not illustrate the resist for plaiting.

### <<Process 3>>

A desired pattern shape (shape of the conductive circuit) of a resist 35 is formed on a surface of the metal foil 20 including a portion where the metal layer 55 is provided by an ink material made of a thermoplastic resin (see Fig. 4(C)).

As a specific example, a desired pattern shape of the resist 35 (thermoplastic resin layer) is formed on the surface of the metal foil 20 including the portion where the metal layer 55 is provided using a polyolefin thermoplastic adhesive or the like which melts at a temperature of about 150°C. The resist 30 is formed by coating to a thickness of about 2 to 3 µm by a method such as gravure printing.

### <<Process 4>>

The metal foil 20 in an exposed position which is not covered with the resist 35 is removed by etching to thereby form the conductive circuit 21. A surface of this conductive circuit 21 is covered with the resist 35 serving as a thermoplastic resin layer, and a portion thereof provided with the metal film 55 is covered with the resist 35 in a manner to sandwich the metal layer 55 (see Fig. 4(D)).

### « Process 5»

A load generated by ultrasonic vibration vibrating in a direction substantially parallel to a surface of the electrode 41 is applied while the surface of the electrode 41 of the electronic component 40 is pressed against the resist 35 serving as the thermoplastic resin layer (see Fig. 4(E)). This process is performed while the insulating base material 10 having the conductive circuit 21 on which the resist 35 or the like is formed is heated to a temperature of about 60°C.

The mechanism in which the electrode 41 of the electronic component 40 and the metal layer 55 are electrically joined together is the same as that in the case of Embodiment 1.

Specifically, by applying a load generated by the ultrasonic vibration while a load by pressure is applied, a part of the resist 35 formed of the thermoplastic resin is removed from the surface of the metal layer 55 by mechanical friction caused by the ultrasonic vibration. To state it differently, a part of the resist 35 melts by frictional heat, and the resin that is melted by pressure is pushed away in a direction perpendicular to a direction in which the pressure is exerted and removed from a region between the surface of the electrode 41 of the electronic component 40 and the surface of the metal layer 55.

At the same time, an oxide layer on the surface of the electrode 41 is also mechanically removed so that the surface of the electrode 41 makes contact with the surface of the metal layer 55. Furthermore, a metal fused portion is formed between these surfaces by the friction caused by the ultrasonic vibration.

Subsequently, by stopping applying the load generated by the ultrasonic vibration, the thermoplastic resin that has been melted by heat is hardened again by cooling. With this arrangement, a resin fixing portion 36 exerting a function of reinforcing the fixing between the insulating base material 10 and the electronic component 40 is formed (see Fig. 4(F)).

As to Process 5, specific examples of a pressure of pressing the electronic component 40, a vibration frequency of the ultrasonic vibration, a duration for applying the load are the same as those in the case of Embodiment 1 as described earlier, and therefore the descriptions thereof will be omitted.

As described above, a similar effect as in the case of Embodiment 1 can also be provided in this embodiment. Also, in this embodiment, by dispersing the particles made of a hard material in a thermoplastic resin layer (resist 35) as described in Embodiment 2, it is possible to increase the frictional force while the load generated by the ultrasonic vibration is applied.

### (Miscellanies)

It is preferable to arrange the thicknesses of the metal layers 50 and 55 in each of the embodiments to be 1 µm or more and 3 µm or less. The reason for setting the thicknesses of the metal layers 50 and 55 to 1 µm or more is that an amount to be scraped off by the ultrasonic friction is taken into account. In the case where the thicknesses of the metal layers 50 and 55 are set to a thickness smaller than 1 µm, it is possible that metal serving as the electrode is absent in the interface, and as a result a probability of causing bonding failure is increased. Further, it serves as a factor to raise the cost to make the thicknesses of the metal layers 50 and 55 larger, and a risk of generating cracks inside the metal layer is caused if the thicknesses are too large. Accordingly, it is preferable that the upper limit of the thicknesses of the metal layers 50 and 55 be about 3 µm.

**DESCRIPTION OF SYMBOLS**

| | |
|---|---|
| 10 | Insulating base material |
| 20 | Metal foil |
| 21 | Conductive circuit |
| 30 | Resist |
| 30a | Resist |
| 30b | Particles |
| 31 | Resin fixing portion |
| 35 | Resist |
| 40 | Electronic component |
| 41 | Electrode |
| 50 | Metal layer |
| 55 | Metal layer |
| 100 | Substrate |

## Claims

1. A method for surface mounting an electronic component, comprising the steps of:
providing, on a substrate member, a conductive circuit, and a thermoplastic resin layer which is formed on a front surface of the conductive circuit;
providing a surface of an electrode of an electronic component with a metal layer; and
bonding the metal layer of the electronic component and the conductive circuit to each other by melting and partially removing a thermoplastic resin by applying a load generated by ultrasonic vibration that vibrates in a direction substantially parallel to a surface of the metal layer, while pressing the metal layer to the thermoplastic resin layer, and then stopping applying the load generated by the ultrasonic vibration, and hardening the thermoplastic resin thus melted by cooling, wherein
the metal layer is configured by a thin layer made of a material having a shear strength lower than that of a material constituting the conductive circuit.

2. The method for surface mounting an electronic component according to claim 1, wherein
particles made of a material having a Mohs hardness larger than that of the material constituting the conductive circuit are dispersed in the thermoplastic resin layer.

3. A method for surface mounting an electronic component, comprising the steps of:
providing, on a substrate member, a conductive circuit, and a metal layer which is formed on a front surface of the conductive circuit;
providing a front surface of the metal layer with a thermoplastic resin layer;
and
bonding an electrode of an electronic component and the metal layer to each other by melting and partially removing a thermoplastic resin by applying a load generated by ultrasonic vibration that vibrates in a direction substantially parallel to a surface of the electrode, while pressing the surface of the electrode to the thermoplastic resin layer, and then stopping applying the load generated by the ultrasonic vibration, and hardening the thermoplastic resin thus melted by cooling, wherein
the metal layer is configured by a thin layer made of a material having a shear strength lower than that of a material constituting the conductive circuit.

4. A substrate having an electronic component mounted thereon, wherein
the electronic component is mounted on a substrate member by the method for surface mounting an electronic component according to claim 1, 2, or 3.
